## Europäisches Patentamt

## European Patent Office

## Office européen des brevets

(19)

(11) **EP 1 219 025 B1**

(12) **EUROPÄISCHE PATENTSCHRIFT**

(45) Veröffentlichungstag und Bekanntmachung des Hinweises auf die Patenterteilung:
**16.11.2005 Patentblatt 2005/46**

(51) Int Cl.⁷: **H03F 1/32**

(21) Anmeldenummer: **00960926.4**

(22) Anmeldetag: **14.09.2000**

(86) Internationale Anmeldenummer:
**PCT/IB2000/001387**

(87) Internationale Veröffentlichungsnummer:
**WO 2001/020776 (22.03.2001 Gazette 2001/12)**

(54) **VERFAHREN ZUR LINEARISIERUNG EINES HOCHFREQUENZ-VERSTÄRKERS**

METHOD FOR LINEARISING A HIGH-FREQUENCY AMPLIFIER

PROCEDE DE LINEARISATION D'UN AMPLIFICATEUR HAUTE FREQUENCE

(84) Benannte Vertragsstaaten:
**AT BE CH CY DE DK ES FI FR GB GR IE IT LI LU MC NL PT SE**

(30) Priorität: **14.09.1999 DE 19943957**

(43) Veröffentlichungstag der Anmeldung:
**03.07.2002 Patentblatt 2002/27**

(73) Patentinhaber: **Marconi Communications GmbH 71522 Backnang (DE)**

(72) Erfinder:
• **HOFMANN, Heike**
  **71522 Backnang (DE)**
• **HAGMANNS, Franz-Josef**
  **D-71522 Backnang (DE)**

(74) Vertreter: **Manitz, Finsterwald & Partner GbR Postfach 31 02 20 80102 München (DE)**

(56) Entgegenhaltungen:
EP-A- 0 731 556          US-A- 5 049 832
US-A- 5 898 338          US-A- 5 903 611

**Beschreibung**

Stand der Technik

Die vorliegende Erfindung betrifft ein Verfahren zur Linearisierung eines Hochfrequenz-Verstärkers, dem ein Vorverzerrer vorgeschaltet ist, in dem ein Vorverzerrungsfaktor adaptiv so verändert wird, daß zwischen dem Ausgangssignal des Hochfrequenz-Verstärkers und dem Eingangssignal des Vorverzerrers ein linearer Zusammenhang besteht.

Das Übertragungsverhalten eines Hochfrequenz-Verstärkers ist stark von seinem Ruhestrom (Vorspannung) abhängig. Je höher der Ruhestrom ist, desto besser ist in der Regel die Linearität des Verstärkers. Mit dem Ruhestrom steigt allerdings die Leistungsaufnahme bzw. sinkt der Wirkungsgrad des Verstärkers. Insbesondere bei Hochfrequenz-Leistungsverstärkern kann dies zu einem erheblichen Aufwand bei der Stromversorgung, der Kühlung u.s.w. führen. Wenn man auf eine hohe Linearität des Verstärkers verzichtet, kann dieser mit einem geringeren Ruhestrom betrieben werden, so daß sich dann der Aufwand bei der Stromversorgung und der Kühlung des Verstärkers verringert. Von einem Betrieb des Verstärkers in seinem linearen Aussteuerbereich kann abgesehen werden, wenn dem Verstärker ein vorverzerrer vorgeschaltet wird, der die Verzerrungen des Verstärkers weitgehend kompensiert. Vorverzerrer für HochfrequenzVerstärker sind aus der Literatur bekannt, z.B. aus IEEE Transactions on Communications, Vol. 45, No. 10, October 1997, S. 1167-1171. Der in diesem Artikel beschriebene adaptive digitale Vorverzerrer arbeitet folgendermaßen. Der Betrag des vorzuverzerrenden Signals wird mit einem reellen Wert multipliziert und zu der Phase wird ein reeller Wert addiert, um die nichtlinearen Effekte des Verstärkers auszugleichen. Die entsprechenden Werte für Betrag und Phase werden aus einer Tabelle ausgelesen, deren Adresse aus der Amplitude des vorzuverzerrenden Signals bestimmt wird. Betrag und Phase werden getrennt adaptiert. Der Korrekturwert zur Steuerung der Adaption des Betrages ist die Differenz der Beträge des Verstärkerausgangssignals und des vorzuverzerrenden Signals. Der Korrekturwert für die Adaption der Phase ist die Differenz der Phasen des verstärkerausgangssignals und des vorzuverzerrenden Signals.

In US-A-5 898 338 ist ein Hochfrequenzverstärker mit einer Einrichtung zur Kompensation von durch den Hochfrequenzverstärker erzeugten Verzerrungen beschrieben. Die digital implementierte, auf Tabellen basierende Einrichtung stellt einen Vorverzerrer dar. Ein Eingangssignal für den Hochfrequenzverstärker wird nach Analog-Digital-Wandlung in einem Analog-Digital-Wandler zum einen zur Ermittlung von Gewichtsfaktoren $W_i$ einem Adressgenerator zugeführt, der eine Adresse in einen RAM ermittelt, an der ein entsprechender Gewichtsfaktor $W_i$ gespeichert ist. Zum anderen wird das digitalisierte Eingangssignal einem Multiplizierer zugeführt, wo es mit einem entsprechenden aus dem RAM ausgelesenen Gewichtsfaktor $W_i$ multipliziert und dem Hochfrequenzverstärker zur eigentlichen Verstärkung zugeführt wird. Zur Adaption der Gewichte $W_i$ wird das digitalisierte Eingangssignal einem Dividierer zugeführt, in dem es durch das Ausgangssignal des Hochfrequenzverstärkers dividiert wird. Das Resultat der Division, eine inverse Verstärkung, wird dann einem Multiplizierer zugeführt, wo es mit einem entsprechenden Gewichtsfaktor $W_j$ zur Bildung eines Schätzwertes für einen neuen Wert des Gewichtsfaktors multipliziert wird. Die mit dem Gewichtsfaktor multiplizierte inverse. Verstärkung wird dann einem Filter zugeführt, von wo sie zur Aktualisierung der Gewichte in das RAM geschrieben wird.

In US-A-5 049 832 ist ein Verfahren zur. Linearisierung eines Verstärkers durch adaptive Vorverzerrung beschrieben. Aus einem Eingangssignal $v_m$ wird ein vorverzerrtes Eingangssignal $v_d$ erzeugt, das von einem Verstärker in ein verstärktes Ausgangssignal $v_a$ umgesetzt wird, so dass für das Ausgangssignal $v_a \cong Kv_m$ gilt, wobei K die konstante Soll-Amplitudenverstärkung des Verstärkers, bezeichnet. Zunächst wird dazu das Betragsquadrat $x_m$ des Eingangssignals $v_m$ ermittelt. Aus einer Tabelle, die $N_t$ Werte $F_i$, i = 0, 1, ... $(N_t-1)$ enthält, wird dann ein Eintrag $F_i$ ausgewählt. Jeder Tabelleneintrag entspricht einem quadrierten Größenwert $x_{mi}$ und für jeden Tabelleneintrag gilt $F_i \cdot G(x_{mi} \cdot | F_i|^2) \cong K$, wobei $G(x)$ die komplexe Verstärkung des Verstärkers bezeichnet. Dabei wird derjenige Tabelleneintrag ausgewählt, für den der Absolutwert $|x_m-x_{mi}|$ in Bezug auf den Tabellenindex i minimiert wird. Das vorverzerrte Signal $v_d$ wird dann, in rechtwinkligen Koordinaten, als $v_d = v_m \cdot F_i$ ermittelt:

$$Re(v_d) = Re(v_m)Re(F_i) - Im(v_m)Im(F)$$

$$Im(v_d) = Re(v_m)Im(F_i) + Im(v_m)Re(F)$$

wobei Re(x) den Realteil von x und Im(x) den Imaginärteil von x bezeichnen.

Der Erfindung liegt nun die Aufgabe zugrunde, ein Verfahren der eingangs genannten Art anzugeben mit dem eine möglichst gute Linearisierung eines Hochfrequenz-Verstärkers erzielt werden kann.

Vorteile der Erfindung

Die genannte Aufgabe wird mit den Merkmalen des Anspruchs 1 dadurch gelöst, daß zunächst der Quotient aus dem Ausgangssignal des Hochfrequenz-Verstärkers und dem Eingangssignal des Vorverzerrers gebildet und dann aus dem Signal-Quotienten eine mittlere Verstärkung bestimmt wird. Für einen im Vorverzerrer gebildeten Vorverzerrungsfaktor wird ein Korrekturterm gebildet, der von der Ablage der mittleren Verstärkung gegenüber einem Sollwert abhängt. Schließlich wird der Vorverzerrungsfaktor adaptiv so verändert, daß der Korrekturterm minimal wird. Gemäß der Erfindung müssen nicht, wie beim zitierten Stand der Technik, der Betrag und die Phase der Signale berechnet werden, sondern es wird der Quotient der Signale gebildet, womit sich mit geringem Rechenaufwand der Korrekturterm für die Adaption bestimmen läßt.

Da mit diesem verfahren die Charakteristik des Vorverzerrers adaptiv eingestellt wird, können auch temperatur- und alterungsabhängige Verstärkungsänderungen kompensiert werden. Eine automatische Adaption des Vorverzerrers im laufenden Betrieb macht außerdem einen Abgleich des Vorverzerrers bei der Herstellung überflüssig..

vorteilhafte Weiterbildungen der Erfindung gehen aus den Unteransprüchen hervor.

Eine besonders gute Konvergenz bei der Adaption des Vorverzerrers stellt sich dadurch ein, daß der Korrekturterm für den Vorverzerrungsfaktor aus dem Produkt einer Adaptionskonstante und der Differenz zwischen der inversen mittleren Verstärkung und 1 gebildet wird.

Es ist zweckmäßig, daß aus dem Eingangssignal des Vorverzerrers die Leistung oder eine daraus abgeleitete Größe gebildet wird, daß dann die Leistung oder die daraus abgeleitete Größe linear quantisiert wird, daß jeder möglichen Quantisierungsstufe ein Wert des Vorverzerrungsfaktors zugeordnet wird, daß zu jeder Quantisierungsstufe eine mittlere Verstärkung bestimmt wird und daß für jeden einer Quantisierungsstufe zugeordneten Verzerrungsfaktor ein von der zu der jeweiligen Quantisierungsstufe ermittelten mittleren Verstärkung abhängiger Korrekturterm gebildet wird, der durch adaptive Veränderung des Vorverzerrungsfaktors minimiert wird. Die mittlere Verstärkung zu jeder Quantisierungsstufe wird vorteilhafter Weise dadurch ermittelt, daß über einen bestimmten Zeitabschnitt aus den zeit- und wertdiskreten Abtastwerten des Ausgangssignals des Hochfrequenz-Verstärkers und des Eingangssignal des Vorverzerrers Verstärkungswerte gebildet werden, daß alle einer jeweiligen Quantisierungsstufe entsprechenden Verstärkungswerte akkumuliert werden und daß für jede Quantisierungsstufe der am Ende des Zeitabschnitts aus der Akkumulation resultierende Verstärkungswert durch die Zahl der Akkumulationsschritte dividiert wird.

Die Adaptionskonstante besitzt vorzugsweise einen von der jeweiligen Quantisierungsstufe, der der Vorverzerrungsfaktor zugeordnet ist, abhängigen Wert.

Eine optimale Adaptionsgeschwindigkeit für den Vorverzerrungsfaktor läßt sich dadurch erreichen, daß als Adaptionskonstante der kleinere von zwei Werten gewählt wird, wobei der eine Wert 0,5 beträgt und der andere Wert von der Zahl der Akkumulationen von Verstärkungswerten in der betreffenden Quantisierungsstufe abhängt.

Beschreibung eines Ausführungsbeispiels

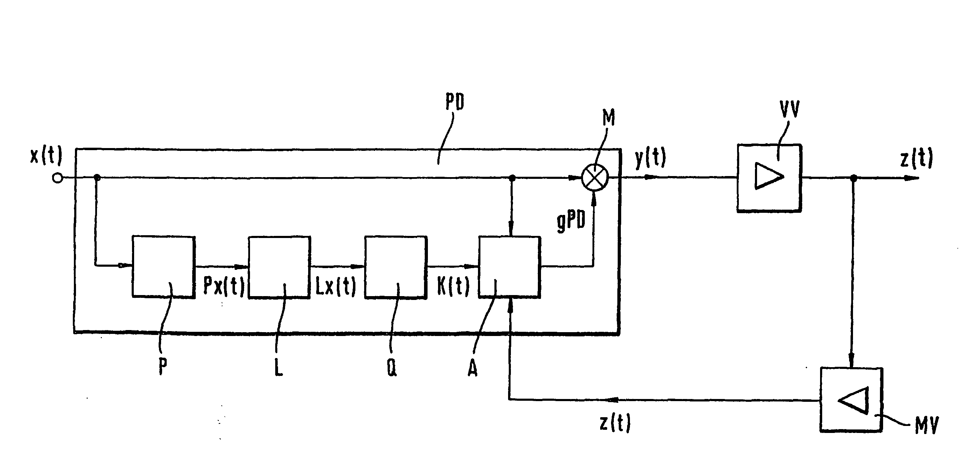

Anhand eines in der Zeichnung dargestellten Ausführungsbeispiels wird,nachfolgend die Erfindung näher erläutert.

Die einzige Figur der Zeichnung zeigt einen Hochfrequenz-Leistungsverstärker VV - im folgenden als Verstärker bezeichnet - und einen diesem vorgeschalteten Vorverzerrer PD. Das Eingangssignal des Vorverzerrers ist mit x(t), das Ausgangssignal des Vorverzerrers PD mit y(t), das dem Eingang des Verstärkers VV zugeführt wird, und das Ausgangssignal des Verstärkers VV mit z(t) bezeichnet. Das Eingangssignal x(t) und daher auch die beiden anderen Signale y(t) und z(t) sind vollständig analytisch, d.h. sie besitzen einen Real- und einen Imaginärteil. Das Eingangssignal x(t) kann ein Basisbandsignal oder ein Signal im Zwischen- oder im Hochfrequenzbereich sein. Für die Transformation der Quadraturkomponenten eines Basisbandsignals in den Zwischen- bzw. Hochfrequenzbereich wird üblicherweise ein Quadraturmischer eingesetzt. Wenn dann im Zwischenfrequenzbereich oder Hochfrequenzbereich ein Signal x(t) vorliegt, das ebenfalls Quadraturkomponenten aufweist, ist die dargestellte Anordnung aus einem Vorverzerrer PD und einem Verstärker VV auch im Zwischen- bzw. Hochfrequenzbereich einsetzbar. Liegt allerdings im Zwischen- oder Hochfrequenzbereich ein Signal x(t) vor, das nur einen Realteil aufweist, so kann der fehlende Imaginärteil auch mit Hilfe eines Hilbert-Filters, das im wesentlichen nur eine Phasenverschiebung von 90° ausführt, aus dem Realteil des Signals gewonnen werden. Bei der nachfolgenden Erläuterung der Schaltung wird von einem Eingangssignal x(t) im Basisband ausgegangen.

Der Zusammenhang zwischen dem Eingangssignal y(t) des Verstärkers VV und seinem Ausgangssignal z(t) läßt sich gemäß Gleichung (1) darstellen.

$$z(t) = gVV(Ay(t)) \cdot y(t) \tag{1}$$

Darin ist Ay (t) = |y(*t*)| . Mit gVV(Ay(t)) ist ein komplexer Verstärkungsfaktor bezeichnet, der nur von der Amplitude Ay(t) des komplexen Eingangssignals y(t) abhängt. Zerlegt man das Eingangssignal y(t) in Betrag und Phase, dann erhält man für das Ausgangssignal z(t) gemäß Gleichung (2):

$$z(t) = fAM,\ VV(Ay(t)) \cdot e^{[fPM,VV(Ay(t))+\Phi y(t)]} \tag{2}$$

Die Amplitude Az(t) und die Phase $\Phi$z(t) des komplexen Ausgangssignals z(t) sind dann gemäß Gleichung (3) und (4):

$$Az(t) = fAM,VV(Ay(t)) \tag{3}$$

$$\Phi z(t) = fPM,\ VV(Ay(t)) + \Phi y(t) \tag{4}$$

In den Gleichungen (2), (3), (4) ist mit fAM, VV eine Amplituden-Amplituden-Konversion und mit fPM, VV eine Amplituden-Phasen-Konversion, die unerwünschter Weise vom Verstärker VV erzeugt werden, bezeichnet. Ein Vergleich der Gleichung (1) mit der Gleichung (2) liefert den Verstärkungsfaktor gemäß Gleichung (5).

$$gVV(Ay(t)) = \frac{fAM,VV(Ay(t))}{Ay(t))} \cdot e^{jfPM,VV(Ay(t))} \tag{5}$$

Der Vorverzerrer PD ist wie der Verstärker VV ein nichtlineares Element. Ein vom Vorverzerrer erzeugter Vorverzerrungsfaktor gPD ist so einzustellen, daß er die Nichtlinearität des Verstärkungsfaktors gVV des nachfolgenden Verstärkers VV kompensiert. Der Zusammenhang zwischen dem Eingangssignal x(t) und dem Ausgangssignal y(t) des Vorverzerrers PD ist in der Gleichung (6) dargestellt.

$$y(t) = gPD(Ax(t)) \cdot x(t) \tag{6}$$

Der Verzerrungsfaktor gPD ist allein von der Amplitude Ax(t) des komplexen Eingangssignals x(t) abhängig. Wie der in der Figur darstellten Schaltung zu entnehmen ist, entsteht das Ausgangssignal y(t) des Vorverzerrers PD dadurch, daß ein Multiplizierer M das Eingangssignal x(t) mit dem Vorverzerrungsfaktor gPD multipliziert. Die Amplitude Ay(t) und die Phase $\Phi$y(t) des komplexen Ausgangssignals y(t) des Vorverzerrers PD lassen sich gemäß den Gleichungen (7) und (8) beschreiben.

$$Ay(t) = fAM,\ PD(Ax(t)) \tag{7}$$

$$\Phi y(t) = fPM,\ PD(Ax(t)) + \Phi x(t) \tag{8}$$

In den Gleichungen (7) und (8) ist mit fAM,PD die Amplituden-Amplituden-Konversion und mit fPM,PD die Amplituden-Phasen-Konversion des Vorverzerrers PD bezeichnet. Setzt man die Gleichungen (7) und (8) in die Gleichungen (3) und (4) ein, so erhält man unter der Nebenbedingung der perfekten Linearisierung, d.h. Az(t) = Ax(t) und $\Phi$z(t) = $\Phi$x(t), die in den Gleichungen (9) und (10) wiedergegebenen Beziehungen zwischen den Amplituden-Amplituden-und Amplituden-Phasen-Konversionen im Verstärker VV und im Vorverzerrer PD.

$$fAM,\ PD(Ax(t)) = f^{-1}AM,\ VV(Ax(t)) \tag{9}$$

$$fPM,\ PD(Ax(t)) = -\ fPM,\ VV(f^{-1}\ AM,\ VV(Ax(t)) \tag{10}$$

In den Gleichungen (9) und (10), welche verifizieren, wie der Vorverzerrer PD zu modellieren ist, so daß die Nichtlinearität des Verstärkers VV kompensiert wird, ist mit $f^{-1}$ die Umkehrfunktion von *f* gemeint. Eine Linearisierung des Verstärkers VV ist also nur in den umkehrbar eindeutigen Bereichen der Verstärkungskennlinie möglich. fAM,PD ist damit ebenfalls umkehrbar eindeutig.

Wie das in der Figur dargestellte Blockschaltbild des Vorverzerrers PD zeigt, werden in einem ersten Funktionsblock P die beiden Quadraturkomponenten des Eingangssignals x(t) quadriert und addiert, so daß am Ausgang die Leistungen Px(t) des Eingangssignals x(t) anliegt. Es gilt also Px(t) = |x (t)|$^2$. Im nächsten Funktionsblock L wird die Leistung Px(t) in eine andere Größe Lx(t) eindeutig abgebildet. Die andere Größe Lx(t) kann z.B. logPx(t) sein. Die Leistung Px(t) muß aber nicht in eine neue Größe Lx(t) umgewandelt werden, sondern kann direkt einem nächsten Funktionsblock Q zugeführt werden. In diesem Funktionsblock Q wird die Eingangsgröße Lx(t) - bzw. direkt die Leistung Px(t) - linear quantisiert. Im darauffolgenden Funktionsblock A, in dem eine Adaption des Vorverzerrungsfaktors gPD stattfindet, ist vorzugsweise zu jeder möglichen Quantisierungsstufe ein Wert des Vorverzerrungsfaktors gPD in einer Tabelle abgelegt. Die Abhängigkeit des Vorverzerrungsfaktors von der Quantisierungsstufe wird im folgenden ausgedrückt durch gPD(K(t)). Die Quantisierungsstufen K(t) stellen dann die Adressen der Tabelle dar, in denen die Vorverzerrungsfaktoren gPD(K(t)) abgelegt sind.

Der Funktionsblock A enthält die Tabelle mit den Vorverzerrungsfaktoren gPD(K(t)) und führt deren Adaption durch. Dazu wird dem Funktionsblock A einerseits das Eingangssignal x(t) des Vorverzerrers PD und andererseits das Ausgangssignal z(t) des Verstärkers VV zugeführt. Das Ausgangssignal z(t) des Verstärkers VV wird von einem Meßempfänger MV aufgenommen, dessen Aufgabe im wesentlichen darin besteht, das Ausgangssignal z(t) des Verstärkers VV wieder in die Frequenzlage, in der der Vorverzerrer realisiert ist, zurückzutransformieren. Es wird hier angenommen, daß der Meßempfänger MV als ideal angesehen werden kann. Das bedeutet, daß er deutlich weniger Verzerrungen produzieren soll als der Verstärker VV, was wegen der deutlich kleineren Signalpegel des Meßempfängers MV leicht zu erfüllen ist. Der Funktionsblock A bildet zunächst den Quotienten aus dem Ausgangssignal z(t) des Verstärkers VV und dem Eingangssignal x(t) des Vorverzerrers PD. Die beiden Signale x(t) und z(t) liegen als zeit- und wertdiskrete Abtastwerte vor, weshalb sie im folgenden als x(n) und z(n) geschrieben werden. Mit n ist der Laufindex für die Abtastwerte innerhalb einer vorgegebenen Zeit bezeichnet. Der Quotient z(n)/x(n) ist dann die momentane Verstärkung im Abtastzeitpunkt n der aus dem Vorverzerrer PD und dem Verstärker VV bestehenden Anordnung.

Wie in der Gleichung (11) dargestellt, werden über den vorgegebenen Zeitabschnitt des Eingangssignals x(n) für jede der vorkommenden Quantisierungsstufen K die in einer durch die Quantisierungsstufen K adressierbaren Tabelle abgelegten Verstärkungswerte ermittelt, indem die zu gleichen Quantisierungsstufen gehörenden Signalquotienten z(n)/x(n) akkumuliert werden.

$$V(K) = V(K) + \frac{z(n)}{x(n)} \tag{11}$$

In der Gleichung (12) wird die Anzahl der Akkumulationen für jede Quantisierungsstufe K gezählt; man kann hier auch von einer Trefferhäufigkeit T(K) für jede Quantisierungsstufe K sprechen.

$$T(K) = T(K) + 1 \tag{12}$$

Dividiert man, wie in der Gleichung (13) angegeben, den am Ende des vorgegebenen Zeitabschnitts vorliegenden Verstärkungswert V(K) durch die Trefferhäufigkeit T(K), so erhält man die mittlere Verstärkung W(K) am Ende des Zeitabschnitts für die jeweilige Quantisierungsstufe K.

$$W(K) = \frac{V(K)}{T(K)} \tag{13}$$

Es sei gPDm(K) der Vorverzerrungsfaktor für die K-tE Quantisierungsstufe im m-ten Zeitabschnitt. Wm(K) sei die im m-ten Zeitabschnitt berechnete mittlerer Verstärkung für die K-te Quantisierungsstufe.

Die Abweichung der mittleren Verstärkung W(K) von einem Sollwert wird als Korrekturwert verwendet, um den Vorverzerrungsfaktor gPD (K) zu adaptieren, bis der Korrekturwert minimal wird. Wird durch Adaption des Vorverzerrungsfaktors gPD (K) der Korrekturwert idealerweise zu 0, so ist die Nichtlinearität des Verstärkungsfaktors gVV (K) vollständig kompensiert- Eine gute Konvergenz bei der Adaption des Vorverzerrungsfaktors gPD (K) auf einen Wert, der eine hohe Linearität der Gesamtanordnung gewährleistet, erreicht man mit der Adaptionsgleichung (14).

$$gPDm + 1(K) = gPDm(K)[1 + \Delta(K)(W^{-1}m(K) - 1)] \tag{14}$$

Diese Adaptionsgleichung (14) besagt, daß der Vorverzerrungsfaktor gPDm+1 (K) für den aktuellen Zeitabschnitt m+1 aus dem Vorverzerrungsfaktor gPDm(K) des vorhergehenden Zeitabschnitts m, dem ein Korrekturwert $gPDm(K) \cdot \Delta(K)(W^{-1}m(K)$-1) überlagert wird, hervorgeht. In dem Korrekturterm ist $\Delta(K)$ eine von der Quantisierungsstufe K abhängige Adaptionskonstante. Des weiteren wird der Korrekturterm durch die Ablage der mittleren Verstärkung von einem Sollwert bestimmt. Im speziellen ist, wie der Gleichung (14) zu entnehmen ist, der Korrekturwert von der Ablage der inversen mittleren Verstärkung $W^{-1}m(K)$ von 1 abhängig. Es hat sich herausgestellt, daß durch den so gebildeten Korrekturwert der Vorverzerrungsfaktor gPD(K) während des Adaptionsvorganges ein gutes Konvergenzverhalten zeigt. Für die Adaptionskonstante $\Delta(K)$ gilt, je kleiner sie ist, desto langsamer läuft die Adaption des Vorverzerrungsfaktors gPD(K) auf einen die Nichtlinearität des Verstärkers VV kompensierenden Wert. Ein langsamer Adaptionsvorgang bedeutet, daß er über mehrere Zeitabschnitte konvergiert, was gleichzusetzen ist mit einem länger dauernden Mittlungsvorgang, so daß Störungen z.B. durch thermisches Rauschen besser unterdrückt werden. Für den Adaptionsvorgang ist darauf zu achten, daß der Vorverzerrungsfaktor sich nicht zu stark von einem Zeitabschnitt zum nächsten ändert. Es hat sich daher als sinnvoll erwiesen, die Adaptionskonstante $\Delta(K)$ von der Anzahl der Treffer T(K), wie in der Gleichung (12) angegebene, abhängig zu machen. Wie die Gleichung (13) für die mittlere Verstärkung W(K) deutlich macht, ist die Mittelung der Verstärkung für diejenigen Quantisierungsstuffen K am stärksten, für die die Trefferquote nach Gleichung (12) am höchsten ist. Es ist sinnvoll, die Adaptionskonstante um so größer werden zu lassen, je stärker die Mittlung der Verstärkung W(K) bzw. die Trefferquote T(K) für die einzelnen Quantisierungsstufen K ist. Eine mögliche Vorgabe für die Adaptionskonstante ist in der Gleichung (15) wiedergegeben.

$$\Delta(K) = \min\{0{,}01\, T(K); 0{,}5\} \tag{15}$$

Diese Gleichung (15) sagt aus, daß die Adaptionskonstante $\Delta(K)$ für die jeweilige Quantisierungsstufe K gleich dem kleineren von zwei Werten gesetzt wird, wobei der eine Wert 0,5 beträgt und der andere Wert einem Hunderstel der Trefferquote T(K) der jeweiligen Quantisierungsstufe K entspricht. Es wird dabei davon ausgegangen, daß zu einem Zeitabschnitt, für den die mittlere Verstärkung W(K) und die Trefferquote T(K) bestimmt werden, etwa 10.000 Abtastwerte gehören.

## Patentansprüche

1. Verfahren zur Linearisierung eines Hochfrequenzverstärkers, dem ein Vorverzerrer (PD) vorgeschaltet ist, in dem ein Vorverzerrungsfaktor (gPD) adaptiv so verändert wird, daß zwischen dem Ausgangssignal (z(t)) des Hochfrequenzverstärkers (VV) und dem Eingangssignal (x(t)) des Vorverzerrers (PD) ein linearer Zusammenhang besteht, wobei der Quotient aus dem Ausgangssignal (z(t)) des Hochfrequenzverstärkers (VV) und dem Eingangssignal (x(t)) des Vorverzerrers (PD) gebildet wird,
**dadurch gekennzeichnet,**
**daß** aus dem Signal-Quotienten eine mittlere Verstärkung bestimmt wird,
**daß** für den Vorverzerrungsfaktor (gPD) ein Korrekturterm gebildet wird, der von der Ablage der mittleren Verstärkung gegenüber einem Sollwert abhängt, und
**daß** der Vorverzerrungsfaktor (gPD) adaptiv verändert wird, so daß der Korrekturterm minimal wird.

2. Verfahren nach Anspruch 1,
**dadurch gekennzeichnet,**
**daß** der Korrekturterm aus dem Produkt einer Adaptionskonstante und der Differenz zwischen der inversen mittleren Verstärkung und 1 gebildet wird.

3. Verfahren nach einem der Ansprüche 1 oder 2,
**dadurch gekennzeichnet,**
**daß** aus dem Eingangssignal (x(t)) des Vorverzerrers (PD) die Leistung (Px(t)) oder eine daraus abgeleitete Größe (Lx(t)) gebildet wird, daß die Leistung (Px(t)) oder die daraus abgeleitete Größe (Lx(t)) linear quantisiert (Q) wird,
**daß** jeder möglichen Quantisierungsstufe (K(t)) ein Wert des Vorverzerrungsfaktors (gPD) zugeordnet wird,
**daß** zu jeder Quantisierungsstufe eine mittlere Verstärkung bestimmt wird, und
**daß** für jeden einer Quantisierungsstufe zugeordneten Vorverzerrungsfaktor (gPD) ein von der zu der jeweiligen Quantisierungsstufe ermittelten mittleren Verstärkung abhängiger Korrekturterm gebildet wird, der durch adaptive Veränderung des Vorverzerrungsfaktors (gPD) minimiert wird.

4. Verfahren nach Anspruch 3, **dadurch gekennzeichnet, daß** die mittlere Verstärkung zu jeder Quantisierungsstufe **dadurch** ermittelt wird, daß über einen bestimmten Zeitabschnitt aus den zeit- und wertdiskreten Abtastwerten des Ausgangssignals (z(t)) des Hochfrequenz-Verstärkers (VV) und des Eingangssignals (x(t)) des Vorverzerrers (PD) Verstärkungswerte gebildet werden, daß alle einer jeweiligen Quantisierungsstufe entsprechenden Verstärkungswerte akkumuliert werden und daß für jede Quantisierungsstufe der am Ende des Zeitabschnitts aus der Akkumulation resultierende Verstärkungswert durch die Zahl der Akkumulationsschritte dividiert wird.

**5.** Verfahren nach den Ansprüchen 2 und 3, **dadurch gekennzeichnet, daß** die Adaptionskonstante einen von der jeweiligen Quantisierungsstufe, der der Vorverzerrungsfaktor (gPD) zugeordnet ist, abhängigen Wert besitzt.

**6.** Verfahren nach den Ansprüchen 4 und 5, **dadurch gekennzeichnet, daß** als Adaptionskonstante der kleinere von zwei Werten gewählt wird, wobei der eine Wert 0,5 beträgt und der andere Wert von der Zahl der Akkumulationen von Verstärkungswerten in der betreffenden Quantisierungsstufe abhängt.

**Claims**

1. A method for linearising a radio frequency amplifier which has a pre-distorter (PD) connected before it and in which a pre-distortion factor (gPD) is adaptively changed such that a linear association exists between the output signal (z(t)) of the radio frequency amplifier (VV) and the input signal (x(t)) of the pre-distorter (PD),
   wherein the quotient is formed from the output signal (z(t)) of the radio frequency amplifier (VV) and from the input signal (x(t)) of the pre-distorter (PD),
   **characterised in that**
   a mean amplification is determined from the signal quotient; **in that** a correction term is formed for the pre-distortion factor (gPD) which depends on the deviation of the mean amplification with respect to a desired value; and **in that** the pre-distortion factor (gPD) is adaptively changed so that the correction term becomes minimal.

2. A method in accordance with claim 1, **characterised in that** the correction term is formed from the product of an adaptation constant and the difference between the inverse mean amplification and 1.

3. A method in accordance with any one of the claims 1 or 2, **characterised in that** the power (Px(t)), or a value (Lx(t)) derived therefrom, is formed from the input signal (x(t)) of the pre-distorter (PD); **in that** the power (Px(t)), or the value (Lx(t)) derived therefrom, is linearly quantified (Q); **in that** a value of the pre-distortion factor (gPD) is associated with every possible quantification stage (K(t)); **in that** a mean amplification is determined with respect to each quantification stage; and **in that** a correction term dependent on the mean amplification determined with respect to the respective quantification stage is formed for each pre-distortion factor (gPD) associated with a quantification stage and is minimised by adaptive change of the pre-distortion factor (gPD).

4. A method in accordance with claim 3, **characterised in that** the mean amplification with respect to each quantification stage is determined **in that** amplification values are formed over a specific time interval from the time-discrete and value-discrete sampling values of the output signal (z(t)) of the radio frequency amplifier (VV) and of the input signal (x(t)) of the pre-distorter (PD); **in that** all amplification values corresponding to a respective quantification stage are accumulated; and **in that** the amplification value resulting from the accumulation at the end of the time interval for each quantification stage is divided by the number of accumulation steps.

5. A method in accordance with claims 2 and 3, **characterised in that** the adaptation constant has a value dependent on the respective quantification stage with which the pre-distortion factor (gPD) is associated.

6. A method in accordance with claims 4 and 5, **characterised in that** the smaller of two values is selected as the adaptation constant, with the one value amounting to 0.5 and the other value depending on the number of accumulations of distortion values in the respective quantification stage.

**Revendications**

1. Procédé de linéarisation d'un amplificateur haute fréquence en amont duquel est branché un dispositif de préaccentuation (PD) dans lequel un facteur de préaccentuation (gPD) est modifié de manière adaptative de telle sorte qu'il y a un rapport linéaire entre le signal de sortie (z(t)) de l'amplificateur haute fréquence (VV) et le signal d'entrée (x(t)) du dispositif de préaccentuation (PD),

le quotient étant formé à partir du signal de sortie (z(t)) de l'amplificateur haute fréquence (VV) et du signal d'entrée (x(t)) du dispositif de préaccentuation (PD),

**caractérisé en ce que** qu'à partir des quotients de signaux, on détermine une amplification moyenne,

**en ce que** pour le facteur de préaccentuation (gPD) est formé un terme de correction qui dépend de la déviation de l'amplification moyenne par rapport à une valeur de consigne, et

**en ce que** le facteur de préaccentuation (gPD) est varié de manière adaptative de telle sorte que le terme de correction est minimal.

**2.** Procédé selon la revendication 1, **caractérisé en ce que** le terme de correction est formé à partir du produit d'une constante d'adaptation et de la différence entre l'amplification moyenne inverse et 1.

**3.** Procédé selon l'une ou l'autre des revendications 1 et 2, **caractérisé en ce que**
à partir du signal d'entrée (x(t)) du dispositif de préaccentuation (PD) est formée la puissance (Px(t)) ou une grandeur (Lx(t)) dérivée de celle-ci, **en ce que** la puissance (Px(t)) ou la grandeur (Lx(t)) dérivée de celle-ci est quantifiée linéairement (Q),
à chaque degré de quantification (K(t)) est associée une valeur du facteur de préaccentuation (gPD),
pour chaque degré de quantification est déterminée une amplification moyenne,
et pour chaque facteur de préaccentuation (gPD) associé à un degré de quantification est formé un terme de correction dépendant de l'amplification moyenne déterminée pour le degré de quantification respectif, terme de correction qui est minimisé par la variation adaptative du facteur de préaccentuation (gPD).

**4.** Procédé selon la revendication 3, **caractérisé en ce que** l'amplification moyenne est déterminée pour chaque degré de quantification par le fait que sur un intervalle temporel déterminé, des valeurs d'amplification sont formées à partir de valeurs de balayage discrètes quant au temps et à la valeur, du signal de sortie (z(t)) de l'amplificateur haute fréquence (VV) et du signal d'entrée (x(t)) du dispositif de préaccentuation (PD), **en ce que** toutes les valeurs d'amplification correspondant à un degré de quantification respectif sont accumulées, et **en ce que** pour chaque degré de quantification, la valeur d'amplification résultant de l'accumulation à la fin de l'intervalle temporel est divisée par le nombre d'étapes d'accumulation.

**5.** Procédé selon les revendications 2 et 3, **caractérisé en ce que** la constante d'adaptation possède une valeur dépendant du degré de quantification respectif auquel est associé le facteur de préaccentuation (gPD).

**6.** Procédé selon les revendications 4 et 5, **caractérisé en ce qu'**on choisit comme constante d'adaptation la plus petite de deux valeurs, une des valeurs étant de 0,5 et l'autre valeur dépendant du nombre des accumulations des valeurs d'amplification dans le degré de quantification concerné.